# EUROPEAN PATENT APPLICATION

(11) **EP 1 191 308 A2**
(43) Date of publication of application: **27.03.2002**
(21) Application number: 01119362.0
(22) Date of filing: 10.08.2001
(51) Int. Cl.: G01D 3/08

(54) **Fault detection method and apparatus**

(30) Priority: 14.09.2000 US 232598 P; 11.04.2001 US 833516
(71) Applicant: Applied Materials, Inc., Santa Clara, California 95054 (US)
(72) Inventor: Reiss, Terry, San Jose, CA 95123 (US); Lymberopoulos, Dimitris P., San Jose, CA 95120 (US)
(74) Representative: Kirschner, Klaus Dieter, Dipl.-Phys.

(57) **Abstract**

A method of fault detection groups together operational parameters of a semiconductor processing tool that correlate with one another to generate a fault detection index. These related active sensors are utilized in the selection process of the nearest neighbor vectors to form a vector subset, and are also considered in generating the fault detection index. Cluster sensors are used in the selection process to select data from the model that matches the cluster sensor value. A passive/inclusive sensor is not used to generate predicted values from a model. The value of a passive/inclusive sensor type is used in calculation of the fault detection index. Synthetic sensors are not utilized in the selection process of the nearest neighbor vectors making up the vector subset, and are not utilized in generating the fault detection index.

## Description

The invention relates to a fault detection method and apparatus.

Semiconductor processing tools are complex and feature a large number of sensors for detecting operational parameters such as pressure, temperature, and electrical power. Requiring the tool operator to independently and simultaneously monitor a large number of sensors in order to detect a tool fault consumes valuable operator attention, and may distract the operator from other important tool management tasks.

With conventional fault detection systems, a fault may be detected through a fault detection index that reflects all of the sensed operational parameters of the tool. However, this approach requires that the operator monitor the value of each sensor because each sensor is treated independently and considered of equal importance in generating the index.

Moreover, where a single sensor malfunctions and emits an erroneous value, conventional fault detection systems may alarm and shut down a processing tool despite otherwise acceptable readings from the other tool sensors. The resulting interruption in tool operation is both expensive and unnecessary.

Multivariate modeling of semiconductor fabrication tools has been employed, resulting in a higher percentage accuracy of fault detection and a greater confidence in fault detection. However, more sophisticated techniques for fault detection are desirable.

A method of fault detection in accordance with one embodiment of the present invention groups together tool operational parameters that correlate with one another. These related active sensors are utilized in the selection process of the nearest neighbor vectors to form a related vector subset, and are also considered in generating the fault detection index from the output prediction vector. This embodiment also utilizes cluster sensors that are used only in the selection of data from the model. Cluster sensors are not considered in generating the fault detection index. Passive/inclusive sensor types are not utilized in the selection process of the nearest neighbor vectors making up the vector subset, but are utilized in generating the fault detection index. This embodiment further utilizes synthetic sensors that are not measured during real time operation of the tool, but which are predicted by the model based upon previous tool operation. Synthetic sensors are not utilized in the selection process of the nearest neighbor vectors, and are also not utilized to generate the fault detection index.

This and other embodiments of the present invention, as well as its advantages and features, are described in more detail in conjunction with the text below and attached figures.
Fig. 1 is a schematic diagram illustrating the steps of one embodiment of a method of fault detection in accordance with the present invention.
Fig. 2A plots values for foreline pressure for an initial series of test runs of a plasma etching tool.
Fig. 2B plots values for foreline pressure for an intermediate series of test runs.
Fig. 2C plots values for foreline pressure for a later series of test runs.
Fig. 3 plots a first fault detection index over a series of test runs.
Fig. 4 plots a second fault detection index over a series of test runs of Figure 3.
Fig. 5 plots a third fault detection index over the series of test runs of Figure 3.
Fig. 6 plots a fourth fault detection index over the series of test runs of Figure 3.
Figs. 7A plots gas 1 inlet pressure for portion Z of the test runs of Figures 3-6
Figs. 7B plots foreline pressure for portion Z of the test runs of Figures 3-6.
Figs. 7C plots throttle valve for portion Z of the test runs of Figures 3-6.
Figs. 7D plots chamber pressure for portion Z of the test runs of Figures 3-6.
Fig. 8A plots fault detection index versus time for a fault detection method which does not utilize cluster sensor information in the selection process of the nearest neighbor vectors.
Fig. 8B plots fault detection index versus time for a fault detection method which utilizes cluster sensor information in the selection process of the nearest neighbor vectors.
Fig. 9A plots actual and predicted susceptor temperature over time for a method in which susceptor temperature is an active sensor type.
Fig. 9B plots actual and predicted susceptor temperature over time for a method in which susceptor temperature is a passive/inclusive sensor type.
Fig. 10 shows a simplified view of an apparatus configured to practice an embodiment of a method in accordance with the present invention.

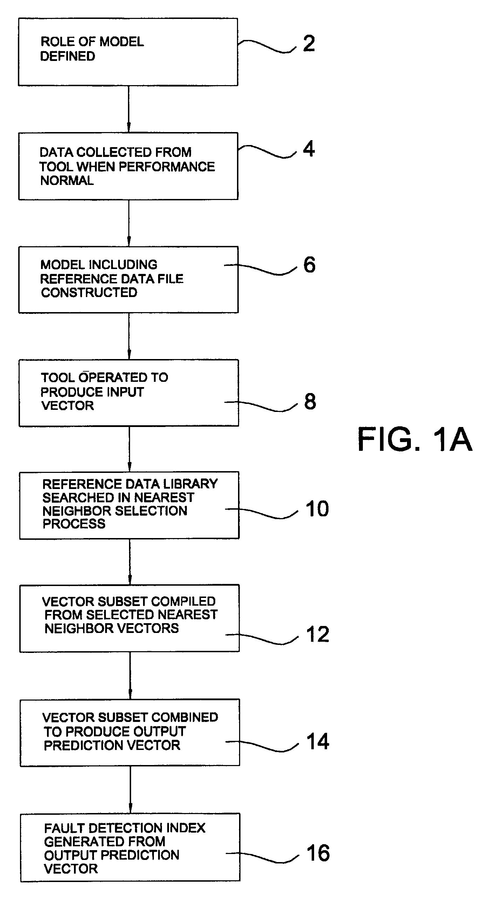

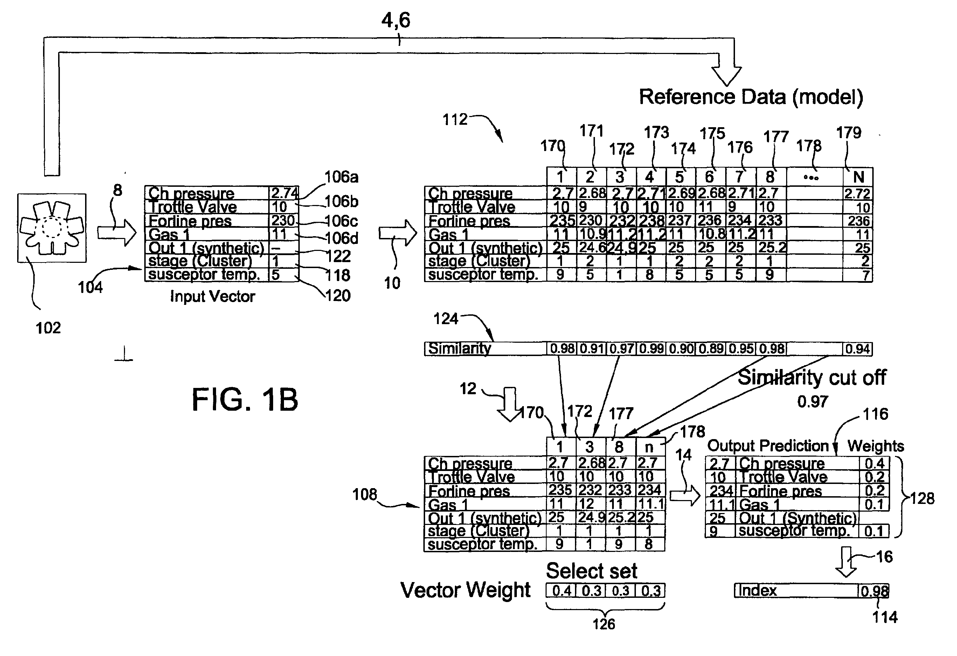

Figure 1 shows a schematic diagram of a method fault detection in accordance with one embodiment of the present invention. Fault detection method 100 is utilized in conjunction with plasma etching tool 102 in Figure 1, but the method in accordance with the present invention is applicable to detecting faults in other semiconductor fabrication tools.

In a first step, the role of the fault detection model is defined. Operational parameters of the plasma etching tool that correlate with one another are grouped together. For example, one group of correlating operational parameters relate to pressure, such as chamber pressure, throttle valve, foreline pressure, and gas 1 pressure. Sensor grouping eliminates coincidences in tool data that could represent a fault when in fact no tool fault has occurred.

Also during definition of the fault detection model, sensor types are assigned to operational parameters. One sensor type are active sensors 106a-d for related operational parameters. Additional sensor types such as cluster sensors 118, passive/inclusive sensors 120, and synthetic sensors 122, are also assigned. The role in fault detection played by each sensor type is discussed in detail below. Sensors are also ranked based upon their importance to fault detection.

In a second method step, data is collected from the tool when the tool performance was at an acceptable level. This collected data represents operational parameters of the tool during proper operation under a specific plasma etching recipe.

In a third step, a model representing operation of the plasma etching tool is constructed. Reference library 112 of unique vectors is compiled from the collected data that reflects proper functioning of the plasma etching tool. The vectors of reference library 112 include active sensors defined by the model.

In a fourth step, plasma etching tool 102 is operated under the specific recipe to produce input vector 104 comprising active sensors 106a-d of chamber pressure 106a, throttle valve 106b, foreline pressure 106c, and gas 1 pressure 106d. Active sensors 106a-d are considered in the process of selecting subset 108 of vectors 110 from reference data library 112, a later step of the fault detection method (see description below). Active sensors 106a-d are also considered in generating fault detection index 114 based upon the difference between input vector 104 and output prediction vector 116 (also see description below).

Input vector 104 also includes cluster sensor 118. Cluster sensor 118 is used to enhance the selection process, and is combined with the nearest neighbor vector selection. The selection process chooses data from the model that closely matches data to the input vector. Cluster sensor 118 is not considered in generating the fault detection index. In the specific example shown in Figure 1, cluster sensor 118 is the step (stage) in the plasma etching process when input vector 104 is measured.

Input vector 104 also includes passive/inclusive sensor 120. Passive/inclusive sensor 120 is a measured operational parameter of the tool that may not correlate as strongly as active sensors 106a-d. Passive/inclusive sensor 120 is not utilized in the section process of nearest neighbor vectors to create vector subset 108. Passive/inclusive sensor 120 is utilized in generating fault detection index 114 from output prediction vector 116. In the specific example shown in Figure 1, passive/inclusive sensor 120 is susceptor temperature.

Input vector 104 further includes synthetic sensor 122. Synthetic sensor 122 is not an operational parameter of the tool that is measured in real time, but its value is included in the vectors of reference data library 112. Synthetic sensor values 122 are difficult or impossible to measure in real time, but can be measured and assigned to a particular vector upon completion of the semiconductor fabrication process. In the specific example shown in Figure 1, synthetic sensor 122 may be the critical dimension, which can only be measured at the conclusion of the etching process. Input of the synthetic sensor 122 is not required by the model, and input vector 104 includes a null value for the synthetic sensor.

In the next step of fault detection method 100, the reference data library compiled in the third step is searched for data that is similar to the input vector. Two tests are employed to gauge similarity between the input vector and the reference data library.

In a first test, input vector 104 is compared with reference data library 112 and similarity factor 124 is generated for each of the vectors of library 112. Vectors having a similarity factor 124 exceeding a cut-off value (0.97 in the case of Figure 1) pass the first test. Similarity factor 124 reflects only similarity to active sensors 106a-d of input vector 104. Passive/inclusive sensor 120 and synthetic sensor 122 are not considered in generating similarity factor 124.

In the second test, cluster sensor 118 of input vector 104 is compared with the cluster sensors of vectors of the reference data library. In the embodiment shown in Figure 1 this comparison may require identity between the cluster sensors. In alternative embodiments however, this comparison may require less demanding criteria to pass the second test.

In the next step of fault detection method 100, vector subset 108 is compiled from the vectors of library 112 that satisfy both the first and the second tests. The vectors of subset 108 include values predicted by the model for the passive/inclusive sensor and the synthetic sensor. Individual vectors 110 of vector subset 108 are then combined to produce an output prediction vector 116. In the specific method shown in Figure 1, output prediction vector 116 is generated by assigning a first set of weights 126 to each vector 110, and then combining the weighted vectors. Alternatively, this vector combination step could utilize no weighting at all, and assign equal weight to each vector of the subset. As yet another alternative, the combination could utilize a weighing system that considers similarity factor 124.

In the final step of the fault detection method 100, fault detection index 114 is generated. A difference between output prediction vector 116 and input vector 104 is first determined. This difference reflects deviation of actual tool operation from expected tool behavior. The active sensors are ranked in terms of relative importance utilizing second set of weights 128, and then combined to produce fault detection index 114. Synthetic sensor 122 and cluster sensor 118 are not considered in producing fault detection index 114.

The roles of the different sensor types in the fault detection method of Figure 1 are summarized below in TABLE A.

**TABLE A**

| **SENSOR TYPE** | **EXAMPLE** | **INPUT REQUIRED?** | **VALUE PRE- DICTED BY MODEL?** | **CORRELATION WITH OTHER ACTIVE SEN- SORS?** | **USED TO SE- LECT VEC- TOR SUB- SET?** | **USED TO CAL- CULATE FAULT DETECTION INDEX?** |
|---|---|---|---|---|---|---|
| Active | chamber pressure | Yes | Yes | Yes | Yes | Yes |
| Passive/ Inclusive | susceptor temperature | Yes | Yes | No | No | Yes |
| Synthetic | out 1 | No | Yes | Not Applic. | No | No |
| Cluster | step | Yes | No | Not Applic. | Yes | No |

One important aspect of embodiments of the present invention is heightened reliability and confidence in fault detection. Specifically, grouping together related operational parameters eliminates coincidences that may be present between unrelated operational parameters. Such coincidences may represent a tool fault when in reality none has occurred.

Another important aspect of embodiments in accordance with the present invention is increased precision in fault detection. By grouping together related active sensors, a low value for the fault detection index permits the operator to focus upon a particular region of the tool where symptoms are detected.

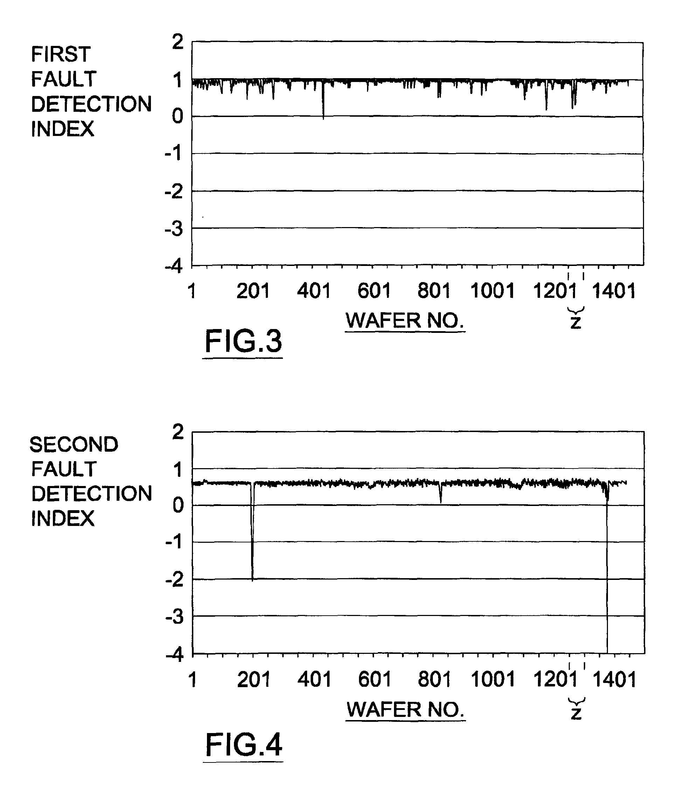

Experimental results of fault detection in accordance with the present invention are now described below in connection with Figures 3A-9B.

### Experimental Results

### I. Sensor Grouping

Plasma etching of oxide layers is frequently performed during the formation of vias in integrated circuits. As a result of oxide etching, polymer materials may accumulate that interfere with correct positioning of the wafer. This can affect product yields. Ordinarily the polymer residues are removed by periodic cleaning steps.

To evaluate a fault detection method in accordance with the present invention, a series of over 1400 consecutive oxide plasma etching runs utilizing an Applied Materials Centura® plasma etching device were performed, without any intervening cleaning steps. Tool sensor information was collected and modeled utilizing Modelware/RT software manufactured by Triant Technologies, Inc. of Nanaimo, British Columbia.

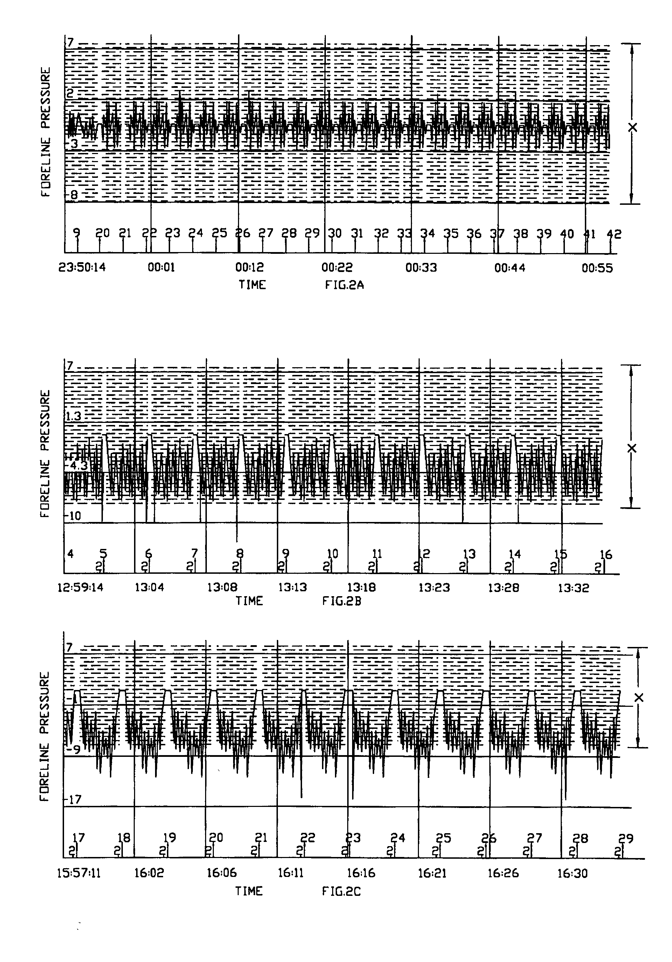

Residual values represent the difference between an actual measured value from the tool and a value predicted by the model. Figs. 2A-2C plot the residual value of foreline pressure, at the beginning, middle, and end of the series of processing runs. Fig. 2A plots values for residual foreline pressure for a beginning portion the 1400 consecutive test runs. Fig. 2A shows that values for residual foreline pressure at first remained comfortably within expected tolerance region X.

Fig. 2B plots values for residual foreline pressure for an intermediate portion of the test runs. Fig. 2B shows a drift in the residual value of foreline pressure to the lowermost portion of tolerance region X.

Fig. 2C plots values for foreline pressure for a later portion of the test runs. Fig. 2C shows that the drift in the residual value of foreline pressure indicated in Fig. 2B has continued, such that the foreline pressure is now out of the tolerance region X. With conventional fault detection methods, this trend would likely alarm the tool and halt wafer production. However, correlation of the foreline pressure data with other tool information, and hence the actual existence of a fault, would remain undetermined. Therefore, the state of the plasma etching tool over the same series of 1400 consecutive processing runs was examined utilizing four fault detection indices including different active sensor groupings. The active sensors of each fault detection index are listed below in TABLE B.

**TABLE B**

| **ACTIVE SENSOR NO.** | **FIRST FAULT DETECTION INDEX** | **SECOND FAULT DETECTION INDEX** | **THIRD FAULT DETECTION INDEX** | **FOURTH FAULT DETECTION INDEX** |
|---|---|---|---|---|
| 1 | chamber pressure | chamber wall temperature | DC bias | chuck current |
| 2 | throttle valve position | chuck temperature | Forward power | chuck voltage |
| 3 | foreline pressure | Heat exchanger temperature | Reflected power | inner helium flow |
| 4 | gas 1 inlet pressure | Cathode temperature | load blade position | outer helium flow |
| 5 | gas 2 inlet pressure | None | tune blade position | inner helium pressure |
| 6 | none | None | None | outer helium pressure |

TABLE B illustrates the reduction in data offered by sensor grouping. Specifically, information of a total of 20 sensors was condensed into just four fault detection indices.

The enhanced precision of fault detection offered by the indices of TABLE B is discussed below in conjunction with Figs. 3-7D. Fig. 3 plots the first fault detection index over the entire processing run of >1400 wafers. This first fault detection index, which focuses upon temperature, does not reveal a fault in the plasma etching tool.

Fig. 4 plots the second fault detection index over the processing run. Apart from a single fault at around wafer 200, this second index focusing upon power also does not reveal a tool fault. The spike at around wafer 200 was associated with etching of a bare silicon wafer lacking an oxide layer, that was inadvertently placed into the etching tool.

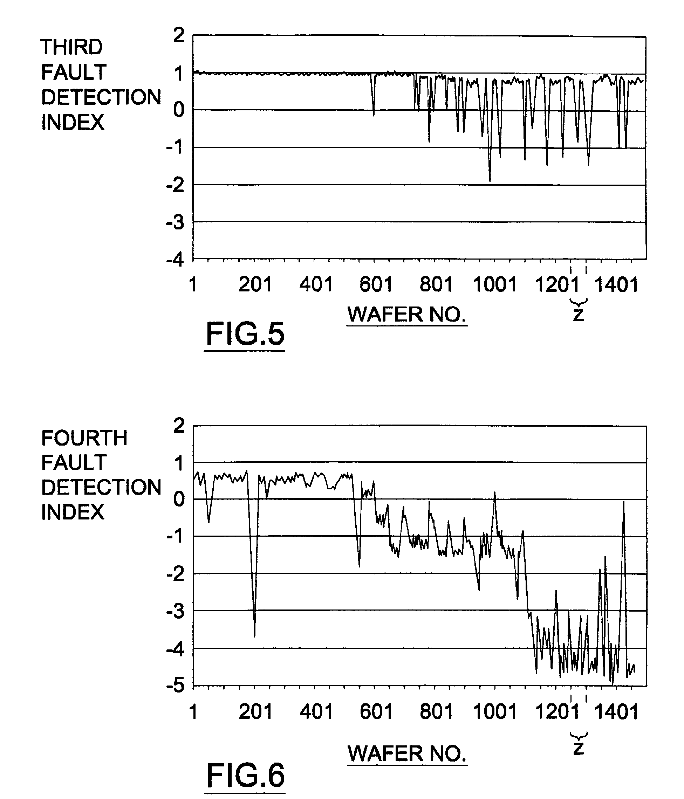

Fig. 5 plots the third fault detection index over the processing run. This third fault detection index, which focuses upon wafer chucking, reveals an initial fault at around wafer 600, followed with increasingly frequent faults. The third fault detection index indicates a likely problem with chucking of the wafer about halfway through the 1400+ test runs. This was likely due to the buildup of residues due to an absence of periodic cleaning steps.

Fig. 6 plots the fourth fault detection index over the processing run. This fourth fault detection index, which focuses upon pressure, reveals a fault at about wafer 200, corresponding to processing of the bare silicon wafer. Moreover, Fig. 6 also reveals an increase in the incidence of tool fault after about wafer number 600. This trend in the fourth fault detection index further indicates a tool fault.

In order to more specifically examine the causes of the tool fault indicated by Figures 5 and 6, Figs. 7A-7D plot four of the five active sensors of the fourth fault detection index during portion "Z" occurring late in the series of processing runs shown in Figs. 3-6.

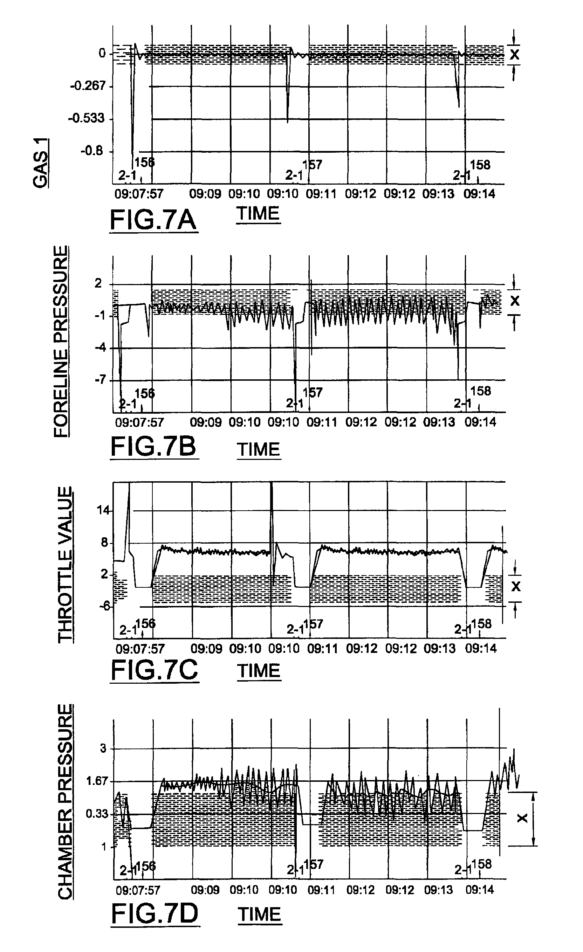

Fig. 7A plots the gas 1 inlet flow. Fig. 7A indicates that the gas 1 flow inlet pressure remained within tolerance band X. The fault indicated by the fourth fault detection index was thus not attributable to gas 1 inlet flow pressure.

Fig. 7B plots foreline pressure sensor for same portion Z of Fig. 7A. Fig. 7B indicates that while the foreline pressure was indeed low, it was only slightly out of tolerance band X.

Fig. 7C plots the throttle valve sensor for the same portion Z of Fig. 7A. Fig. 7D plots the chamber pressure sensor for portion Z. Figs. 7C and 7D reveal that the throttle valve and chamber pressure lie substantially out of the acceptable tolerance range.

The value of these sensor readings, and their correlation to one another, confirm the existence of a tool fault as revealed by the decline in foreline pressure of Figs. 2A-2C. When combined, the throttle value, foreline pressure, and chamber pressure active sensors account for the decline in the fourth fault detection index, and provide a more accurate picture of the status of the plasma etching tool than any single sensor considered independently.

### B. Cluster Sensor

While the above experimental results illustrate the impact of sensor grouping in revealing the existence of a tool fault, utilization of the cluster sensor also enhances fault detection.

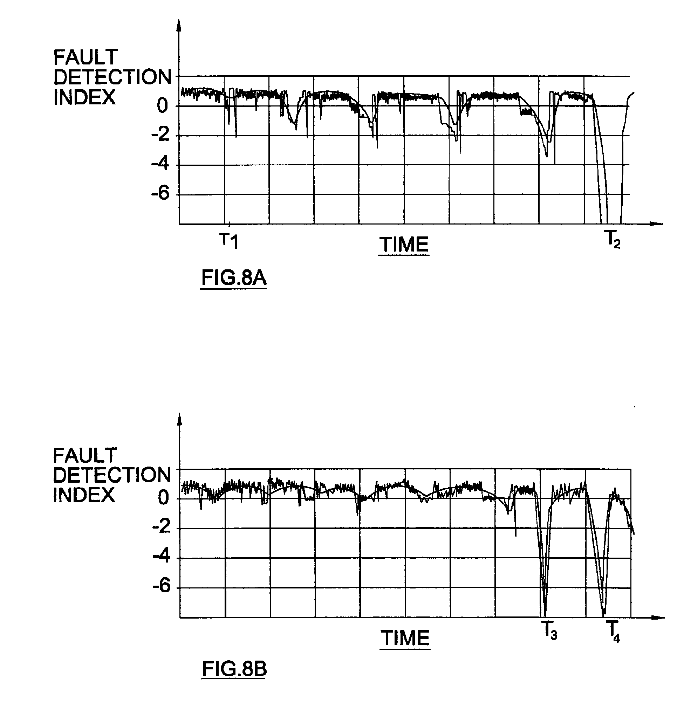

Fig. 8A plots a fault detection index versus time for a process run of a plasma etching tool experiencing a tool fault. The method of Fig. 8A considers the value of the cluster sensor in the selection process of the nearest neighbor vectors to compile the vector subset. Fig. 8A represents a highly accurate picture of the status of the tool, with the fault detection index progressively worsening from time T₁ until the tool is ultimately halted and alarmed at time T₂.

By contrast, Fig. 8B plots the same process run where the value of the cluster sensor is not considered in the selection process of the nearest neighbor vectors to compile the vector subset. Fig. 8B represents a less accurate picture of the status of the tool, with an abrupt drop in the fault detection index occurring at time T₃ immediately prior to alarming and halting of the tool at time T₄. The advance warning of a fault provided by the method of Fig. 8A affords the tool operator significant lead time to recognize and correct a fault. Early fault recognition would prevent scrapping of wafers falling outside of acceptable tolerances, raising tool yields.

### C. Passive/Inclusive Sensor

Utilization of the passive/inclusive sensor type also provides benefits in fault detection. For example, an operational parameter such as susceptor temperature may provide important fault detection information. However, susceptor temperature does not correlate strongly with the related pressure sensors shown in Fig. 1.

If the susceptor temperature is defined as an active sensor, it is automatically considered in the nearest neighbor selection process. This is undesirable where the fault detection index is to be based upon other, related sensors.

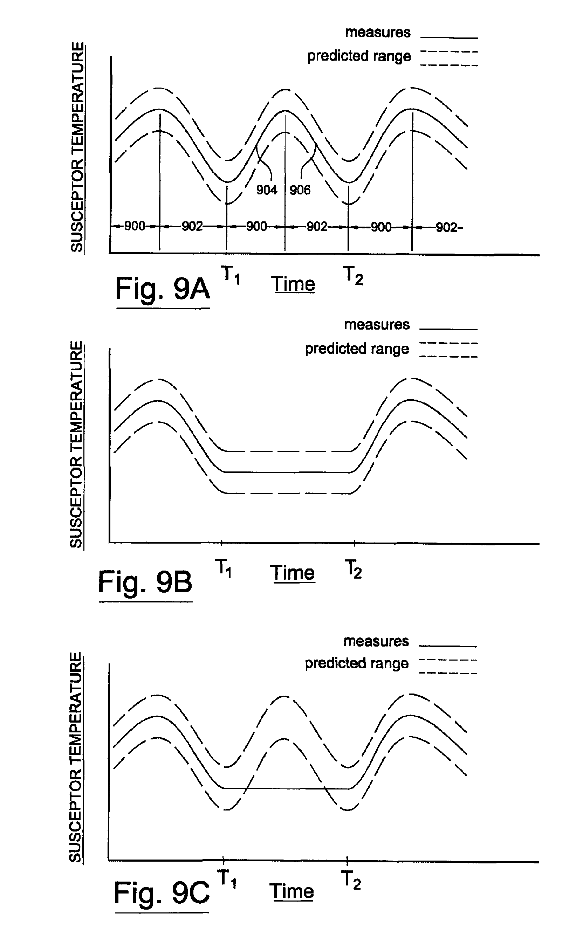

Fig. 9A plots measured susceptor temperature and predicted susceptor temperature range over time, in a predictive model in which susceptor temperature is an active sensor type. Fig. 9A indicates that at time T₁, the measured susceptor temperature departs from its expected cyclical behavior, remaining flat through T₂. Susceptor temperature does not correlate strongly with the group of related active pressure sensors. However, because susceptor temperature is an active sensor type and is considered in selection of the nearest neighbor vectors, the model reflects the flat shape in the predicted susceptor temperatures range that conforms to the change in actual temperature. This change in predicted temperature masks the potential tool fault indicated by the flat profile of actual temperature between times T₁ and T₂.

By contrast, Fig. 9B plots the measured susceptor temperature and a second predicted susceptor temperature range over time, in a predictive model in which susceptor temperature is a passive-inclusive sensor type. The measured susceptor temperature is not considered in selecting the nearest neighbor vectors of the subset. Therefore, the predicted susceptor temperature range does remain flat at time T₁ to match the actual value. In Fig. 9B the flat profile in actual susceptor temperature beginning at time T₁ passes outside of the predicted range and is thus recognizable as a potential tool fault.

### Apparatus for Fault Detection

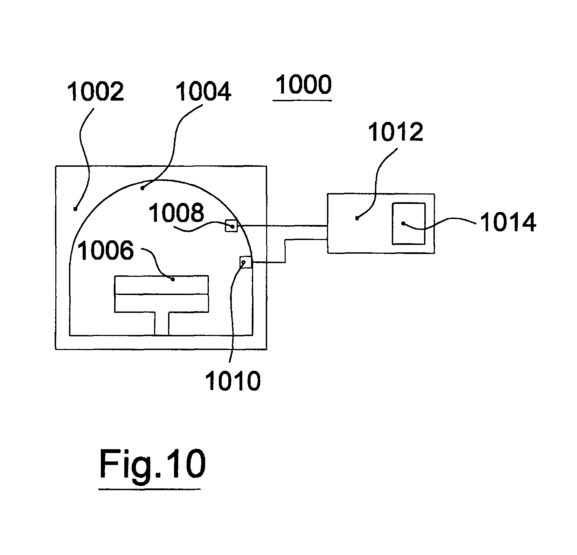

Fig. 10 shows a simplified view of an apparatus configured to practice an embodiment of a method in accordance with the present invention. Apparatus 1000 includes semiconductor fabrication tool 1002 including wafer processing chamber 1004 having wafer 1006 positioned therein. Apparatus 1000 also includes first sensor 1008 and second sensor 1010 operatively coupled to tool 1002 to detect operational parameters of tool 1002.

Controller 1012 is in communication with tool 1002, and with first and second sensors 1008 and 1010. Memory 1014 is coupled to controller 1012, and memory 1014 stores a computer program in computer readable format including computer instructions to control said apparatus to sense a group of correlating operational parameters from the semiconductor processing tool operating under a recipe, to compare only the group of correlating operational parameters to corresponding operational parameters recorded during prior runs of the tool utilizing the recipe, and to generate a fault detection index from comparing the sensed group of operational parameters to the corresponding operational parameters recorded during prior runs.

While the present invention has been described in Fig. 1 in conjunction with detecting a fault in a plasma etching tool, the semiconductor fabrication tool of Fig. 10 is not limited to this specific embodiment. In accordance with one alternative embodiment of the present invention, a fault in a chemical-mechanical polishing (CMP) apparatus could be detected. In accordance with other alternative embodiments of the present invention, faults in other semiconductor fabrication tools such as chemical vapor deposition tools and lithography apparatuses could be detected.

In addition, the above invention has been described in conjunction with a fault detection method utilizing selection of nearest neighbor vectors from a reference data library, this is not required by the present invention. The technique of grouping together sensors that correlate with one another to create fault detection indices could be utilized in other modeling approaches, and the method would still remain within the scope of the present invention.

## Claims

1. A fault detection method comprising:
- sensing a group of correlating operational parameters of a semiconductor processing tool operating under a recipe;
- comparing only the group of correlating operational parameters to corresponding operational parameters recorded during prior runs of the tool utilizing the recipe; and
- generating a fault detection index from comparing the sensed group of operational parameters to the corresponding operational parameters recorded during prior runs.

2. The method of claim 1 wherein sensing the group of correlating operational parameters comprises sensing operational parameters relating to tool pressure and/or to tool temperature and/or to tool power and/or to positioning of a wafer within the tool.

3. The method of claim 1 wherein generating the fault detection index comprises:
- forming an input vector including the sensed group of operational parameters;
- comparing the input vector to a reference data library comprising vectors from previous tool runs utilizing the recipe;
- selecting from the reference data library nearest neighbor vectors to the input vector based upon a similarity to the input vector;
- compiling a vector subset from the selected nearest neighbor vectors;
- combining the vector subset into an output prediction vector;
- calculating a difference between the input vector and the output prediction vector; and
- generating a fault detection index from the difference.

4. The method of claim 3 wherein combining the operational parameters of the output prediction vector comprises assigning a set of weights to the operational parameters of the output prediction vector; and adding together the weighted operational parameters.

5. The method of claim 4 wherein the set of weights are assigned based upon the similarity.

6. The method of claim 3 further comprising:
- including in the input vector a value of a passive-inclusive sensor,
- ignoring the value of the passive-inclusive sensor in selecting the nearest neighbor vectors; and
- including the value of the passive-inclusive sensor in generating the fault detection index from the difference.

7. The method of claim 6 further comprising:
- including in the input vector a value of a cluster sensor;
- selecting the nearest neighbor vectors based upon a comparison of the cluster sensors; and
- ignoring the cluster sensor in generating the fault detection index from the difference.

8. The method of claim 7 wherein the cluster sensor represents a stage in a semiconductor fabrication process when the group of operational parameters is sensed.

9. The method of claim 3 wherein the vectors of the reference data library include a synthetic sensor, the method further comprising:
- including in the input vector a null value of the synthetic sensor; and
- obtaining a predicted value of the synthetic sensor from the output prediction vector, the synthetic sensor ignored in selecting the nearest neighbor vectors and in generating the fault detection index from the difference.

10. The method of claim 9 wherein the synthetic sensor is difficult or impossible to measure in real time during operation of the semiconductor fabrication tool, and is assigned to the vectors of the library after completion of the processing.

11. An apparatus for detecting a fault in a semiconductor processing tool, the apparatus comprising:
- sensor means operatively coupled to the semiconductor processing tool;
- a controller in communication with the semiconductor processing tool and with the sensor means; and
- a memory coupled to the controller, the memory storing a computer program in computer readable format including computer instructions to control said controller to carry out the method of any of the preceding claims.

12. The apparatus of claim 11 wherein the sensor means comprise a first sensor and a second sensor.
